# EUROPEAN PATENT APPLICATION

(11) **EP 4 498 769 A1**
(43) Date of publication of application: **29.01.2025**
(21) Application number: 24157113.2
(22) Date of filing: 12.02.2024
(51) Int. Cl.: H05K 5/02, G03G 21/16

(54) **HOUSING STRUCTURE**

(30) Priority: 26.07.2023 JP 2023121389
(71) Applicant: FUJIFILM Business Innovation Corp., Minato-ku Tokyo (JP)
(72) Inventor: SHINOTO, Keigo, Kanagawa (JP)
(74) Representative: Haseltine Lake Kempner LLP

(57) **Abstract**

A housing structure includes: a first frame; a second frame positioned below the first frame and provided with a handle part, the second frame having an action surface that extends in a direction crossing the vertical direction and on which the external force applied to the handle part acts; and an accommodation part accommodating a substrate positioned between the first frame and the second frame, the accommodation part including an overlapping part overlapping the action surface of the second frame in an up-down direction.

## Description

### Background

### (i) Technical Field

The present disclosure relates to a housing structure.

### (ii) Related Art

For example, Japanese Unexamined Patent Application Publication No. 2012-33801 discloses the configuration of an electronic device housing including a box-shaped nonflammable case whose top face is open and a box-shaped nonflammable lid whose bottom face is open, the lid being engaged with the case so as to cover the case. The case includes at least one first partition plate rising from the bottom face of the case and substantially extending across the bottom face, and the lid includes at least one second partition plate suspended from the top face of the lid and substantially extending across the top face. When the case and the lid are engaged, the first partition plate and the second partition plate are arranged substantially parallel to each other with an extremely narrow gap, for preventing fire from passing through, therebetween.

### Summary

Here, in a housing including two frames arranged so as to cross the vertical direction and not being in contact with each other in the vertical direction, the insufficiency of rigidity may arise, for example, when a load is exerted on one frame in the vertical direction upon lifting the housing.

Accordingly, it is an object of the present disclosure to secure, when two frames arranged so as to cross the vertical direction and not being in contact with each other in the vertical direction are applied with a load in the vertical direction, the rigidity of a housing without providing a new frame that is disposed so as to cross the vertical direction and is in contact with the two frames.

According to a first aspect of the present disclosure, there is provided a housing structure including: a first frame; a second frame positioned below the first frame and provided with a handle part, the second frame having an action surface that extends in a direction crossing the vertical direction and on which the external force applied to the handle part acts; and an accommodation part accommodating a substrate positioned between the first frame and the second frame, the accommodation part including an overlapping part overlapping the action surface of the second frame in an up-down direction.

According to a second aspect of the present disclosure, there is provided a housing structure according to the first aspect, in which the handle part is positioned below the action surface of the second frame and is a hollow part recessed, toward an inner side of the second frame, to form an inner surface including an upper-side inner surface that is a guiding surface for guiding a finger of a user in a depth direction.

According to a third aspect of the present disclosure, there is provided a housing structure according to the second aspect, in which an end portion of the hollow part in the depth direction is positioned within a section corresponding to the overlapping part.

According to a fourth aspect of the present disclosure, there is provided a housing structure according to any one of the first to third aspects, in which, in the accommodation part, when external force is applied to the handle part of the second frame, a predetermined portion of the overlapping part receives the external force from the action surface and transmits the external force to the first frame.

According to a fifth aspect of the present disclosure, there is provided a housing structure according to the fourth aspect, in which the predetermined portion is apart from the action surface when no external force is applied to the handle part.

According to a sixth aspect of the present disclosure, there is provided a housing structure according to any one of the first to fifth aspects, in which the second frame does not include a portion directed downward from the action surface.

According to a seventh aspect of the present disclosure, there is provided a housing structure according to any one of the first to sixth aspects, in which the accommodation part is made of a nonflammable resin.

According to the first aspect of the present disclosure, when two frames arranged so as to cross the vertical direction and not being in contact with each other in the vertical direction are applied with a load in the vertical direction, the rigidity of a housing can be secured without providing a new frame that is disposed so as to cross the vertical direction and is in contact with the two frames.

According to the second aspect of the present disclosure, a load can be suppressed from concentrating on a finger of a user holding the handle part compared with when there is no adoption of the configuration in which the handle part is positioned below the action surface of the second frame and is the hollow part recessed, toward the inner side of the second frame, to form the inner surface including the upper-side inner surface that is the guiding surface for guiding a finger of a user in the depth direction.

According to the third aspect of the present disclosure, the strength of the accommodation part can be secured compared with when there is no adoption of the configuration in which the end portion of the hollow part in the depth direction is positioned within the section corresponding to the overlapping part.

According to the fourth aspect of the present disclosure, the rigidity of the housing can be secured compared with when there is no adoption of the configuration in which, in the accommodation part, when external force is applied to the handle part of the second frame, the predetermined portion of the overlapping part receives the external force from the action surface and transmits the external force to the first frame.

According to the fifth aspect of the present disclosure, the improvement of assembly workability can be intended compared with when there is no adoption of the configuration in which the predetermined portion is apart from the action surface when no external force is applied to the handle part.

According to the sixth aspect of the present disclosure, the effective use of an inside space can be intended compared with when there is no adoption of the configuration in which the second frame does not include a portion directed downward from the action surface.

According to the seventh aspect of the present disclosure, the fire-resistive performance of the accommodation part can be improved compared with when there is no adoption of the configuration in which the accommodation part is made of a nonflammable resin.

### Brief Description of the Drawings

Exemplary embodiments of the present disclosure will be described in detail based on the following figures, wherein:
Fig. 1 illustrates the overall configuration of an image forming apparatus;
Fig. 2 is a schematic perspective view partially illustrating a housing of the image forming apparatus;
Fig. 3 is a schematic perspective view illustrating the housing with an outer-side member that covers a substrate, being attached to the housing;
Fig. 4 is a vertical sectional view including a lower-side member and an upper-side member;
Fig. 5 is a partial enlarged view of a region V of Fig. 4;
Figs. 6A and 6B are given for the description of a gap between an action surface of the lower-side member and a deeper-side end portion of an inner-side member, Fig. 6A illustrating an instance with the gap, the Fig. 6B illustrating an instance without the gap; and
Fig. 7 is a schematic view illustrating a supporting post configuration of the inner-side member.

### Detailed Description

Hereinafter, exemplary embodiments of the present disclosure will be described in detail with reference to the accompanying drawings. Note that the sizes and thicknesses of, for example, parts illustrated in the drawings referred to in the following description are sometimes differ from the dimensions of the actual parts.

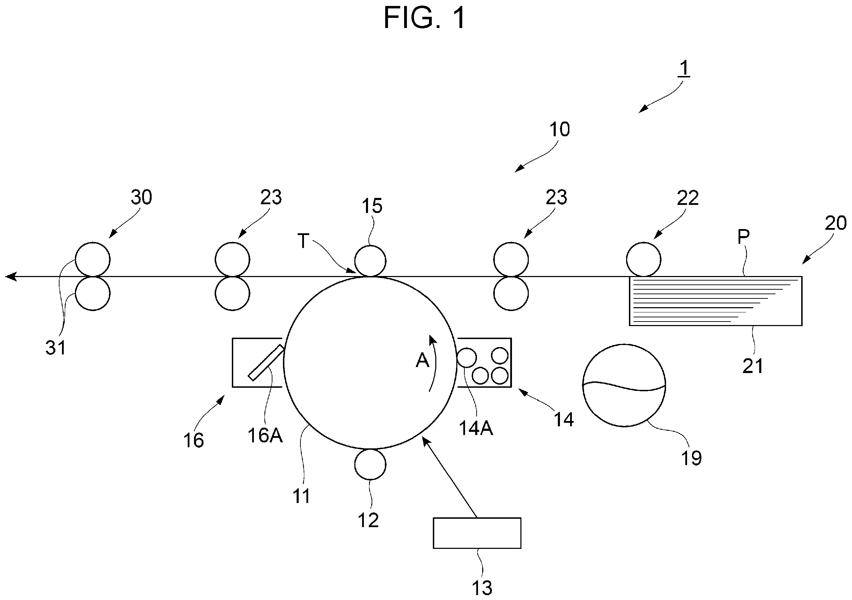

Fig. 1 illustrates the overall configuration of an image forming apparatus 1. Specifically, Fig. 1 illustrates the image forming apparatus 1 when viewed from the front side relative to the image forming apparatus 1.

The image forming apparatus 1 includes an image forming unit 10, a sheet feeding unit 20, and a fixing unit 30.

The image forming unit 10, by using an electrophotographic system, forms a toner image on a paper sheet P that is an example of a recording material. The sheet feeding unit 20 feeds a paper sheet P to the image forming unit 10. The fixing unit 30 fixes, to a paper sheet P, a toner image, that is, an image, formed on the paper sheet P by the image forming unit 10.

The image forming unit 10 includes a photoconductor drum 11 that rotates in the direction indicated by arrow A. The image forming unit 10 further includes a charging roller 12, an exposure device 13, a developing device 14, a transfer roller 15, and a cleaning device 16.

The photoconductor drum 11 is constituted by a cylindrical body. A photosensitive layer, which is not illustrated, is formed on a surface of the cylindrical body.

The charging roller 12 is constituted by, for example, a rubber roller having conductivity and charges the photoconductor drum 11.

The exposure device 13 irradiates the photoconductor drum 11 that has been charged by the charging roller 12, with light from a light source such as a laser light source or a light emitting diode (LED), and the exposure device 13 thus forms an electrostatic latent image on the surface of the photoconductor drum 11.

The developing device 14 includes a developing roller 14A that develops, with a toner of a predetermined color, the electrostatic latent image that has been formed on the photoconductor drum 11, by causing the toner to stick to the surface of the photoconductor drum 11. Thus, in the present exemplary embodiment, the toner image is formed on the surface of the photoconductor drum 11.

The developing device 14 stores a developer. The developer of the present exemplary embodiment is a so-called two-component developer constituted by a carrier having magnetic properties and a colored toner.

In the present exemplary embodiment, a developer storage container 19 storing the developer that is supplied to the developing device 14 is further provided. In the present exemplary embodiment, the developer is supplied anew from the developer storage container 19 to the developing device 14 through a developer transport path, which is not illustrated.

The transfer roller 15 is constituted by, for example, a rubber roller having conductivity.

In the present exemplary embodiment, a transfer part T is a spot where the transfer roller 15 and the photoconductor drum 11 face each other, and, at the transfer part T, the toner image on the surface of the photoconductor drum 11, that is, the toner image held by the photoconductor drum 11 is transferred onto the transported paper sheet P.

The cleaning device 16 incudes a contact member 16A disposed while being in contact with the photoconductor drum 11, and the cleaning device 16 removes the matter, such as a toner, sticking onto the photoconductor drum 11.

Note that the present exemplary embodiment employs the configuration in which the transfer roller 15 performs transfer onto a paper sheet P, but is not limited thereto and may employ a configuration in which the transfer roller 15 performs transfer onto an intermediate transfer belt, which is not illustrated.

The sheet feeding unit 20 includes a sheet storage container 21 storing a paper sheet P and a sending mechanism 22 that sends out a paper sheet P from the sheet storage container 21.

In the present exemplary embodiment, a sheet transport mechanism 23 that transports the paper sheet P that has been sent out from the sheet feeding unit 20, via the transfer part T and the fixing unit 30 is further provided.

The fixing unit 30 includes a pair of rotating bodies 31 that rotate while being in contact with each other.

One rotating body 31 of the pair of rotating bodies 31 includes, thereinside, a heat source, which is not illustrated.

At the fixing unit 30, the two rotating bodies 31 apply pressure and heat to a paper sheet P, thereby fixing the toner image on the paper sheet P to the paper sheet P.

An image forming operation at the image forming apparatus 1 will be described.

At the image forming unit 10, the charging roller 12 charges the photoconductor drum 11 rotating in the direction of arrow A. Next, the exposure device 13 performs exposure, thereby forming an electrostatic latent image corresponding to image information, on the surface of the photoconductor drum 11.

Subsequently, the developing device 14 performs development, thereby forming a toner image corresponding to the electrostatic latent image, on the surface of the photoconductor drum 11.

The toner image formed on the photoconductor drum 11 moves toward the transfer part T with the rotation of the photoconductor drum 11. The paper sheet P sent out from the sheet feeding unit 20 is transported to the transfer part T by the sheet transport mechanism 23.

The toner image on the photoconductor drum 11 is then transferred onto the paper sheet P that has been transported to the transfer part T. Subsequently, the paper sheet P onto which the toner image has been transferred passes through the fixing unit 30, thereby being applied with heat and pressure; thus, the toner image is fixed on the paper sheet P.

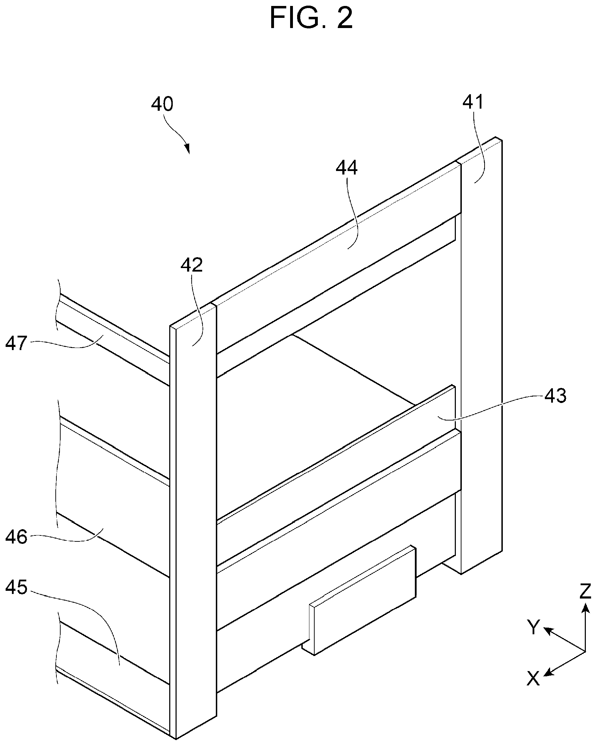

Fig. 2 is a schematic perspective view partially illustrating a housing 40 of the image forming apparatus 1. With reference to the figure, description will be made by using the X direction, the Y direction, and the Z direction. The Z direction is a height direction, an up-down direction, or a top-bottom direction, and is the vertical direction. The X direction is a width direction or the lateral direction and crosses the vertical direction. The Y direction is a depth direction and crosses the vertical direction.

As Fig. 2 illustrates, the housing 40 includes members 41 and 42 extending in the Z direction and includes a lower-side member 43 and an upper-side member 44 extending in the X direction and positioned apart from each other in the Z direction. Note that, although being partially omitted in Fig. 2, the housing 40 also includes members 45 to 47 extending in the Y direction.

More specifically, the lower-side member 43 is positioned below the upper-side member 44. That is, the lower-side member 43 and the upper-side member 44 are arranged so as to cross the Z direction and are not in contact with each other in the Z direction.

The lower-side member 43 is coupled to the members 41 and 42, and the upper-side member 44 is also coupled to the members 41 and 42. That is, in the example of Fig. 2, there is a space surrounded by the members 41 and 42, the lower-side member 43, and the upper-side member 44, and, in the space, there is no frame of the housing connected to the lower-side member 43 and the upper-side member 44 in the vertical direction.

Here, the lower-side member 43 is an example of a second frame, and the upper-side member 44 is an example of a first frame.

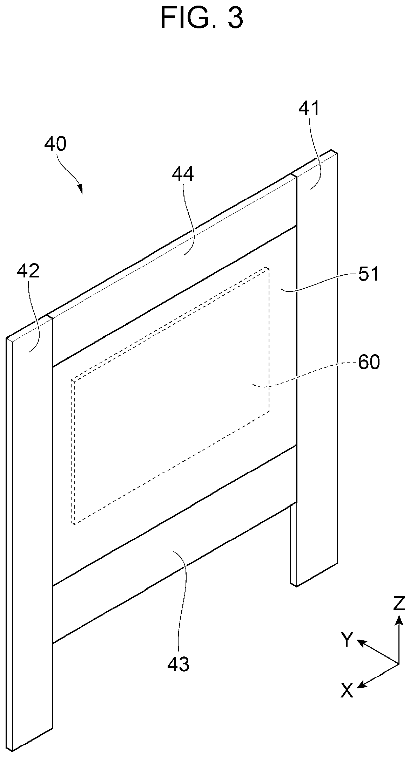

Fig. 3 is a schematic perspective view illustrating the housing 40 with an outer-side member 51 that covers a substrate 60, being attached the housing 40, and members such as the members 45 to 47 (refer to Fig. 2) are omitted from Fig. 3.

The substrate 60 illustrated by a broken line in Fig. 3 is positioned between the lower-side member 43 and the upper-side member 44 and is a printed circuit board for achieving a function of the image forming apparatus 1 (refer to Fig. 1). More specifically, the substrate 60 is for high-voltage power feed and requires a fire prevention enclosure so as to minimize the spread of the fire or the flames from the inside.

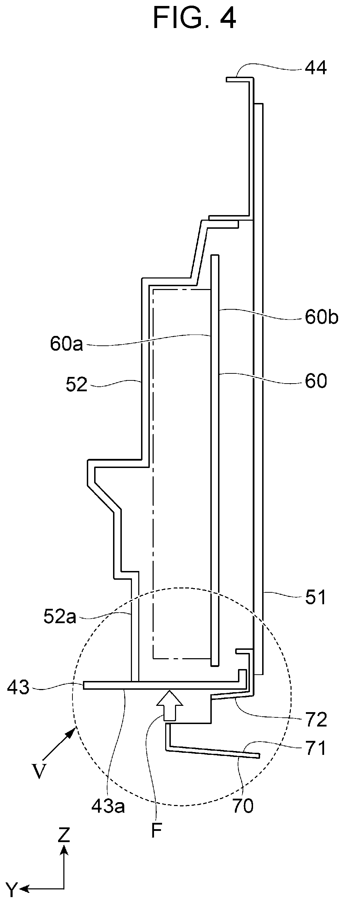

The fire prevention enclosure for the substrate 60 of the present exemplary embodiment includes the outer-side member 51 and an inner-side member 52 (refer to Fig. 4), which will be described later. The outer-side member 51 is a plate-shaped member, and the inner-side member 52 has a recessed portion. Thus, the recessed portion of the inner-side member 52 is used to accommodate the substrate 60, and the outer-side member 51 separates the space of the inner-side member 52 from the outside.

The inner-side member 52 is an example of an accommodation part.

Fig. 4 is a vertical sectional view including the lower-side member 43 and the upper-side member 44 and is a sectional view including the Y direction and the Z direction.

As Fig. 4 illustrates, the substrate 60 is disposed such that a solder surface 60b is positioned on the outer-side member 51 side, and a component mount surface 60a is positioned on the inner-side member 52 side. Note that, in the figure, on the component mount surface 60a, a region in which a component can be mounted is illustrated by a dot-and-dash line.

The inner-side member 52 has a shape with which a space accommodating the substrate is formed, and the inner-side member 52 supports a load. The inner-side member 52 is made of a nonflammable resin.

The outer-side member 51 is a covering member made of metal and having a plate shape as described above, thereby not serving as a member for supporting a load.

More specifically, when the external force (not illustrated) that bends the outer-side member 51 acts on the outer-side member 51, the external force is transmitted to the inner-side member 52 having a rigidity higher than the outer-side member 51, and the outer-side member 51 is thereby suppressed from being bent. Thus, the outer-side member 51 is prevented from coming into contact with the substrate 60.

Here, handle parts 70 are provided below the lower-side member 43. The handle parts 70 are used when the image forming apparatus 1 (refer to Fig. 1) is lifted, and the handle parts 70 are arranged in the X direction (for example, refer to Fig. 2) at spacing. The number of the handle parts 70 is, for example, two so as to enable the lifting with both hands.

The handle parts 70 and the lower-side member 43 may be formed as one body or may be separated members.

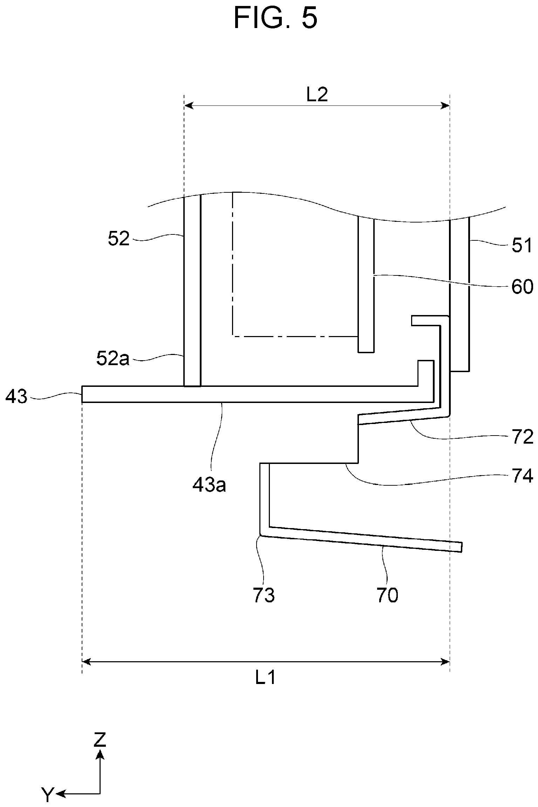

The handle parts 70 are each a hollow part recessed toward the inner side of the lower-side member 43 (in the Y direction), thereby forming an inner surface 71. The inner surface 71 includes an upper-side inner surface 72 (refer to Fig. 5) that is a surface for guiding a finger of a user in the Y direction. Thus, the user touches the upper-side inner surfaces 72 with fingers when holding the handle parts 70, and a load is thereby suppressed from concentrating on the fingers.

The upper-side inner surface 72 is an example of a guiding surface for guiding a finger of a user in the depth direction.

The lower-side member 43 has an action surface 43a extending in the Y direction, that is, a direction crossing the vertical direction, and, when external force F is applied to the handle part 70, the external force F acts on the action surface 43a. The action surface 43a is a lower surface of the lower-side member 43. The handle parts 70 are positioned below the action surface 43a.

Note that, in the present exemplary embodiment, the handle parts 70 are each formed by the hollow part; however, the handle parts 70 are not limited thereto and may each be formed by a grasping part or a grip part (not illustrated).

More specifically, the lower-side member 43 does not include a portion directed downward from the action surface 43a due to bending. Thus, the effective use of the inside space of the housing 40 is intended. Note that such a portion directed downward from the action surface 43a is a portion formed due to bending by which the inside space is limited. Thus, the lower-side member 43 may have a step portion, not a bend portion, as long as the inside space is not virtually limited.

Fig. 5 is a partial enlarged view of a region V of Fig. 4 and illustrates the relationship between the action surface 43a of the lower-side member 43 and the handle part 70.

As Fig. 5 illustrates, when, in the lower-side member 43, the action surface 43a on which the external force F (refer to Fig. 4) acts is a part L1, the handle part 70 includes an overlapping part L2 overlapping the part L1 in the up-down direction.

Thus, the rigidity of the housing can be secured without, for example, a new member disposed so as to cross the Z direction and being in contact with the lower-side member 43 and the upper-side member 44.

As Fig. 5 illustrates, an end portion 73, in the Y direction, of the handle part 70, that is, the hollow part is positioned within a section corresponding to the overlapping part L2. Thus, the inner-side member 52 can serve as a member for supporting the housing.

In the present exemplary embodiment, the handle part 70 has a cutout 74 allowing user's finger inserted in the handle part 70 to access the action surface 43a of the lower-side member 43. Note that, instead of the configuration with the cutout 74, there may be adopted a configuration in which the handle part 70 comes into contact with the action surface 43a of the lower-side member 43 upon the application of the external force F to the handle part 70.

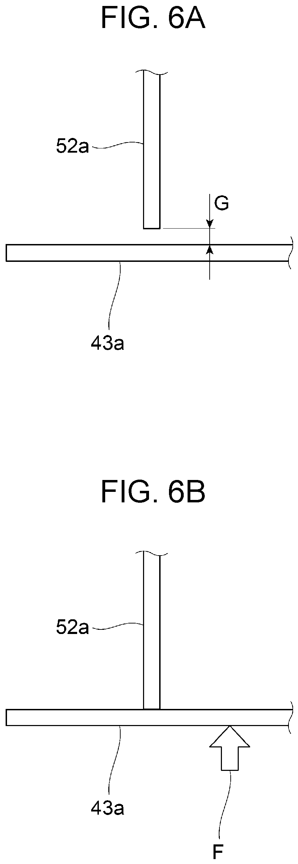

Figs. 6A and 6B are given for the description of a gap G between the action surface 43a of the lower-side member 43 and a deeper-side end portion 52a of the inner-side member 52, Fig. 6A illustrating an instance with the gap G, the Fig. 6B illustrating an instance without the gap G.

When no external force F is applied to the handle part 70 (for example, refer to Fig. 5), as Fig. 6A illustrates, the deeper-side end portion 52a of the inner-side member 52 and the action surface 43a are apart from each other, and there is thus the gap G. That is, when no external force F is applied to the handle part 70, the deeper-side end portion 52a of the inner-side member 52 is apart from the action surface 43a.

On the other hand, when the external force F is applied to and thus acts on the action surface 43a, as Fig. 6B illustrates, the action surface 43a is bent in the Z direction to come into contact with the deeper-side end portion 52a, and the gap G thereby disappears. Thus, the deeper-side end portion 52a receives the external force F from the action surface 43a and transmits the external force F to the upper-side member 44.

The present exemplary embodiment employs the configuration in which the gap G is left unless the upward external force F acts, thereby intending the improvement of the assembly workability of the housing.

The deeper-side end portion 52a of the inner-side member 52 is an example of, in the overlapping part, a predetermined portion.

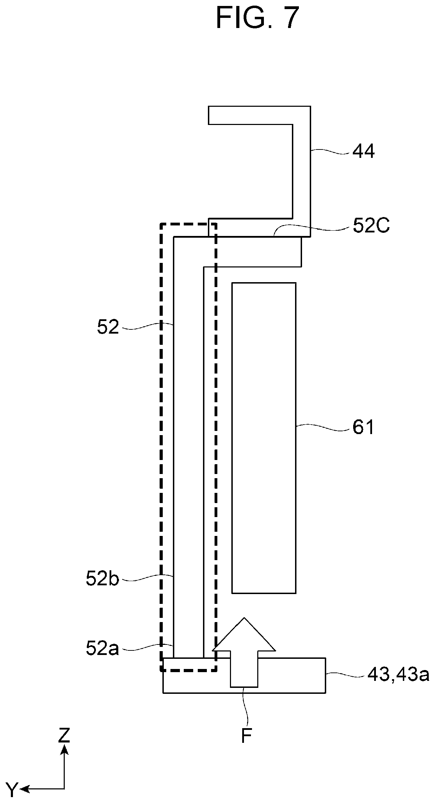

Fig. 7 is a schematic view illustrating a supporting post configuration of the inner-side member 52.

As Fig. 7 illustrates, the inner-side member 52 includes a high rigidity region 52b, within a broken line, whose rigidity in the Z direction is high. The high rigidity region 52b includes the deeper-side end portion 52a that is in contact with the lower-side member 43 when the upward external force Facts.

The high rigidity region 52b further includes an upper end portion 52c of the inner-side member 52. The upper end portion 52c is not a portion that is in contact with the upper-side member 44 even when no external force F acts, and, as Fig. 7 illustrates, the upper end portion 52c is in contact with the upper-side member 44 upon the action of the external force F. Note that the upper end portion 52c is not limited thereto and may be coupled to the upper-side member 44.

The inner-side member 52, due to the high rigidity region 52b within the broken line, functions as, for example, a supporting post that supports the load of the external force F, which is directed upward, and transmits the load to the upper-side member 44.

Thus, when the upward external force F exerted from the handle part 70 (refer to Fig. 4) acts on the action surface 43a of the lower-side member 43, the high rigidity region 52b in the inner-side member 52 transmits the external force F to the upper-side member 44. Without providing a new member, the rigidity of the housing is secured by providing the high rigidity region 52b in the inner-side member 52 constituting a portion of the fire prevention enclosure.

The foregoing description of the exemplary embodiments of the present disclosure has been provided for the purposes of illustration and description. It is not intended to be exhaustive or to limit the disclosure to the precise forms disclosed. Obviously, many modifications and variations will be apparent to practitioners skilled in the art. The embodiments were chosen and described in order to best explain the principles of the disclosure and its practical applications, thereby enabling others skilled in the art to understand the disclosure for various embodiments and with the various modifications as are suited to the particular use contemplated. It is intended that the scope of the disclosure be defined by the following claims and their equivalents.

### Appendix

(((1))) A housing structure comprising:
a first frame;
a second frame positioned below the first frame and provided with a handle part, the second frame having an action surface that extends in a direction crossing a vertical direction and on which external force applied to the handle part acts; and
an accommodation part accommodating a substrate positioned between the first frame and the second frame, the accommodation part including an overlapping part overlapping the action surface of the second frame in an up-down direction.

(((2)))The housing structure according to (((1))), wherein:
the handle part is positioned below the action surface of the second frame and is a hollow part recessed, toward an inner side of the second frame, to form an inner surface including an upper-side inner surface that is a guiding surface for guiding a finger of a user in a depth direction.

(((3)))The housing structure according to (((2))), wherein:
an end portion of the hollow part in the depth direction is positioned within a section corresponding to the overlapping part.

(((4)))The housing structure according to any one of (((1))) to (((3))), wherein:
in the accommodation part, when external force is applied to the handle part of the second frame, a predetermined portion of the overlapping part receives the external force from the action surface and transmits the external force to the first frame.

(((5)))The housing structure according to (((4))), wherein:
the predetermined portion is apart from the action surface when no external force is applied to the handle part.

(((6))) The housing structure according to any one of (((1))) to (((5))), wherein:
the second frame does not include a portion directed downward from the action surface.

(((7)))The housing structure according to any one of (((1))) to (((6))), wherein:
the accommodation part is made of a nonflammable resin.

According to (((1))) of the present disclosure, when two frames arranged so as to cross the vertical direction and not being in contact with each other in the vertical direction are applied with a load in the vertical direction, the rigidity of a housing can be secured without providing a new frame that is disposed so as to cross the vertical direction and is in contact with the two frames.

According to (((2))) of the present disclosure, a load can be suppressed from concentrating on a finger of a user holding the handle part compared with when there is no adoption of the configuration in which the handle part is positioned below the action surface of the second frame and is the hollow part recessed, toward the inner side of the second frame, to form the inner surface including the upper-side inner surface that is the guiding surface for guiding a finger of a user in the depth direction.

According to (((3))) of the present disclosure, the strength of the accommodation part can be secured compared with when there is no adoption of the configuration in which the end portion of the hollow part in the depth direction is positioned within the section corresponding to the overlapping part.

According to (((4))) of the present disclosure, the rigidity of the housing can be secured compared with when there is no adoption of the configuration in which, in the accommodation part, when external force is applied to the handle part of the second frame, the predetermined portion of the overlapping part receives the external force from the action surface and transmits the external force to the first frame.

According to (((5))) of the present disclosure, the improvement of assembly workability can be intended compared with when there is no adoption of the configuration in which the predetermined portion is apart from the action surface when no external force is applied to the handle part.

According to (((6))) of the present disclosure, the effective use of an inside space can be intended compared with when there is no adoption of the configuration in which the second frame does not include a portion directed downward from the action surface.

According to (((7))) of the present disclosure, the fire-resistive performance of the accommodation part can be improved compared with when there is no adoption of the configuration in which the accommodation part is made of a nonflammable resin.

## Claims

1. A housing structure comprising:
a first frame;
a second frame positioned below the first frame and provided with a handle part, the second frame having an action surface that extends in a direction crossing a vertical direction and on which external force applied to the handle part acts; and
an accommodation part accommodating a substrate positioned between the first frame and the second frame, the accommodation part including an overlapping part overlapping the action surface of the second frame in an up-down direction.

2. The housing structure according to claim 1, wherein:
the handle part is positioned below the action surface of the second frame and is a hollow part recessed, toward an inner side of the second frame, to form an inner surface including an upper-side inner surface that is a guiding surface for guiding a finger of a user in a depth direction.

3. The housing structure according to claim 2, wherein:
an end portion of the hollow part in the depth direction is positioned within a section corresponding to the overlapping part.

4. The housing structure according to any one of claims 1 to 3, wherein:
in the accommodation part, when external force is applied to the handle part of the second frame, a predetermined portion of the overlapping part receives the external force from the action surface and transmits the external force to the first frame.

5. The housing structure according to claim 4, wherein:
the predetermined portion is apart from the action surface when no external force is applied to the handle part.

6. The housing structure according to any one of claims 1 to 5, wherein:
the second frame does not include a portion directed downward from the action surface.

7. The housing structure according to any one of claims 1 to 6, wherein:
the accommodation part is made of a nonflammable resin.
